# EUROPEAN PATENT SPECIFICATION

(11) **EP 4 440 251 B1**
(45) Date of publication and mention of the grant of the patent: **05.08.2026**
(21) Application number: 23869730.4
(22) Date of filing: 14.06.2023
(51) Int. Cl.: H05K 1/02, H05K 1/11, H05K 9/00

(54) **CIRCUIT BOARD ASSEMBLY AND ELECTRONIC DEVICE**
LEITERPLATTENANORDNUNG UND ELEKTRONISCHE VORRICHTUNG
ENSEMBLE CARTE DE CIRCUIT IMPRIMÉ ET DISPOSITIF ÉLECTRONIQUE

(30) Priority: 28.09.2022 CN 202222603719 U
(43) Date of publication of application: 02.10.2024
(73) Proprietor: Honor Device Co., Ltd., Shenzhen, Guangdong 518040 (CN)
(72) Inventor: LV, Ye, Shenzhen, Guangdong 518040 (CN); MENG, Yin, Shenzhen, Guangdong 518040 (CN)
(74) Representative: Beder, Jens
(86) International application number: PCT/CN2023/100091
(87) International publication number: WO 2024/066481

(56) References cited:
- CN-A- 106 028 627
- CN-A- 113 766 822
- CN-A- 115 023 099
- CN-U- 213 694 596
- CN-U- 219 087 379
- KR-A- 20220 130 387
- US-A1- 2004 022 046
- US-A1- 2006 134 982
- US-A1- 2012 218 727
- US-B1- 6 958 445

## Description

This application claims priority to Chinese Patent Application CN 219 087 379 U (Application No. 202222603719.7), filed with the China National Intellectual Property Administration on September 28, 2022 and entitled "CIRCUIT BOARD ASSEMBLY AND ELECTRONIC DEVICE".

### TECHNICAL FIELD

This application relates to the field of electronic device technologies, and in particular, to a circuit board assembly and an electronic device.

### BACKGROUND

Currently, a device layout of a circuit board shows a development trend of high density. In the device layout of the circuit board, there is a scenario in which a shielding cover and a chip are disposed back-to-back. However, this arrangement may lead to poor maintainability of the circuit board and reduce operating reliability of the circuit board. US 2012/218727 A1 discloses a circuit board assembly comprising a circuit board and a shielding cover soldered to the circuit board using reflow soldering. The shielding cover includes a main body, flanges and supports. The main body is formed of a metal in a box shape and it has an opening in a surface thereof. The flanges horizontally extend outward from edges of the opening and are integrally formed with the main body. The supports are electrically conductive and are coupled to the lower surfaces of the flanges through a material formed by soldering or welding. A flange of the shielding cover may comprise a recess of a size sufficient to accommodate the support. The lower surface of the flange out of the recess flushes with a solder cream disposed under the support thereby electrically contacting the shielding cover with a ground pattern formed on the circuit board.

US 2006/134982 A1 discloses a circuit board assembly comprising a circuit board and a removable shielding cover attached to the circuit board using soldered clips.

US 2004/022046 A1 discloses a circuit board assembly, in which a shielding cover comprises a flange attached to a circuit board using an adhesive tape strip.

### SUMMARY

Embodiments of this application provide a circuit board assembly and an electronic device to the enclosed independent claims that can improve maintainability and reliability of a circuit board based on ensuring that a shielding cover has good operating reliability. Advantageous features of the present invention are defined in the corresponding subclaims. In the following, parts of the description and drawings referring to embodiments, which are not covered by the claims, are not presented as embodiments of the invention but as examples useful for understanding the invention.

According to a first aspect, this application provides a circuit board assembly according to the independent claim 1. The circuit board assembly includes:
a circuit board, where the circuit board includes a first surface and a second surface that are disposed opposite to each other;
a chip, where the chip is disposed on the second surface;
a shielding cover, where the shielding cover includes a main body and a flange, the main body defines accommodation space, the flange is connected to one end of the main body in a peripheral direction of the main body, an angle is formed between the flange and the main body, the flange is connected to the first surface, a recess is provided on a surface of the flange facing the first surface, and the recess runs through the flange in a width direction of the flange and is communicated with the accommodation space; and
a conductive structure, where the conductive structure is located in the recess and connected between a top wall of the recess and the first surface, and orthographic projection of the conductive structure on the circuit board at least partially falls within an orthographic projection range of the chip on the circuit board.

It may be understood that with a development trend of high density of a device layout on the circuit board, there may be a scenario in which the chip and the shielding cover are disposed back-to-back. In this scenario, when it is necessary to perform maintenance operations such as disassembly and welding on the shielding cover for repairing and diagnosing a component in the shielding cover, because the shielding cover is directly attached to the chip back-to-back, problems such as chip failure due to adhesive explosion and increased stress on a solder joint of the chip may easily occur. This further increases a risk of failure of the circuit board assembly and worsens maintainability and operating reliability of the circuit board assembly.

Therefore, the recess is provided in a part where the conductive cover is attached to the chip back-to-back, and the conductive structure is located in the recess and connected between the conductive cover and the circuit board. The conductive structure may be located at a position where the shielding cover is attached to the chip back-to-back, so that when the shielding cover is repaired, the shielding cover may not be directly attached to the chip back-to-back due to a presence of the conductive structure. When the shielding cover is repaired, there is no need to heat the part where the shielding cover is attached to the chip back-to-back, so that the chip may not be directly heated, and the risk of the adhesive explosion of the chip is low. In addition, the conductive structure may be located at the position where the shielding cover is attached to the chip back-to-back, and the conductive structure is attached to the chip back-to-back due to the presence of the conductive structure. A stress on the shielding cover during the maintenance operation can be absorbed by the conductive structure and a stress on the solder joint of the chip is reduced. Moreover, a part of the structure of the shielding cover is replaced with the conductive structure, still ensuring a shielding effect and performance of the shielding cover, and the maintainability and operating reliability of the circuit board assembly are better.

In a possible implementation, the conductive structure includes a compressed state and a natural state.

When the conductive structure is in the compressed state, the conductive structure is connected between the shielding cover and the circuit board.

When the conductive structure is in the natural state, the conductive structure is connected to the shielding cover and separated from the circuit board, or the conductive structure is connected to the circuit board and separated from the shielding cover.

It may be understood that when the conductive structure is in the natural state, the conductive structure may be connected to the shielding cover and separated from the circuit board, so that the shielding cover and the conductive structure are combined together and fed as a whole, so as to be connected together to a first solder pad on the first surface. Specifically, the conductive structure may be connected to the top wall of the recess. For example, the conductive structure may be adhered on the top wall of the recess.

Alternatively, when the conductive structure is in the natural state, the conductive structure may be connected to the circuit board and separated from the shielding cover, so that the conductive structure and the shielding cover are two parts and are respectively connected to the first solder pad on the first surface. For example, the conductive structure may be welded or adhered to the first solder pad of the circuit board.

When the conductive structure is in the compressed state, the conductive structure is connected between the shielding cover and the circuit board. Specifically, the conductive structure is connected between the top wall of the recess and the first solder pad. For example, the conductive structure is adhered on the top wall of the recess and welded to the first solder pad. Specifically, the conductive structure may be welded to the first solder pad of the circuit board first, and then the shielding cover is welded to the circuit board. Alternatively, the conductive structure may be adhered to the recess of the shielding cover first, and then the shielding cover with the conductive structure adhered is welded to the first solder pad of the circuit board. In both of the foregoing methods, the conductive structure may be in contact with the flange of the shielding cover. During a reflow soldering process, an auxiliary structure may also be added and pressed against the main body of the shielding cover to avoid a problem of false welding caused by expansion of the conductive structure.

According to the invention, the recess includes the top wall, a first side wall, and a second side wall, the top wall is connected between the first side wall and the second side wall, the conductive structure is in contact with the top wall, and the conductive structure is spaced apart from both the first side wall and the second side wall.

It may be understood that the conductive structure is spaced apart from both the first side wall and the second side wall, and a gap may be left so that the gap may be used as expansion space for the conductive structure to expand, thereby effectively avoiding the problem of false welding between the shielding cover and the circuit board due to the expansion of the conductive structure, and achieving good reliability.

In a possible implementation, distances/a distance between the conductive structure and the first side wall and/or the second side wall are/is in a range from 0.2 mm to 0.5 mm.

In a possible implementation, the first solder pad is disposed on the first surface, and the first solder pad is in contact with the conductive structure, or the first solder pad and the conductive structure are connected via a solder material. Therefore, a mounting manner of the conductive structure may be flexibly selected according to different application scenarios.

According to the invention, the first solder pad is in contact with the conductive structure, and the conductive structure is configured to be pressed against the first solder pad by an external structural member located on a side of the flange facing away from the circuit board.

It may be understood that the conductive structure electrically connects the circuit board and the shielding cover under a pressure exerted by the external structural member, thereby achieving the shielding effect and performance of the shielding cover. In this way, because the part where the shielding cover is attached to the chip back-to-back is not welded with a soldering material, there is no need to heat the first solder pad and a second solder pad of the corresponding parts of the chip when the shielding cover is repaired, so that the chip may not be directly heated, and the risk of adhesive explosion of the chip is low. In addition, the stress on the shielding cover is absorbed by the conductive structure, and the stress on the solder joint of the chip is reduced.

According to the invention, the circuit board assembly further includes an electronic component, the electronic component is disposed on the first surface and is located in the accommodation space, and the conductive structure is spaced apart from the electronic component.

In this way, a short circuit problem caused by collision between the conductive structure and the electronic component located inside the accommodation space can be avoided, and the circuit board assembly has good operating reliability.

In a possible implementation, a spacing between the conductive structure and the electronic component is in a range from 0.3 mm to 0.5 mm.

In a possible embodiment, a length of the conductive structure is less than or equal to a length of the main body.

In this way, a part or almost all of one edge of the flange may be replaced with a conductive structure according to needs of application scenarios, and other edges of the flange are still made of a material of the shielding cover.

In a possible embodiment, the conductive structure includes a plurality of substructures, the plurality of substructures are spaced apart from each other, each substructure is connected between the top wall of the recess and the first surface, and a distance between two adjacent substructures is less than or equal to 1.2 mm.

In this way, the conductive structure may be designed into a plurality of small sections to fully consider a spacing between two adjacent first solder pads and a requirement for electromagnetic shielding, to facilitate further expanding a size of the shielding cover. In addition, based on a contact form in which the shielding cover is in contact with the first solder pad via the substructure, a problem of poor welding between the shielding cover and the first solder pad can be resolved, coplanarity between the shielding cover and the first solder pad can be ensured, and a thickness of the circuit board assembly can be reduced to a certain extent.

In a possible embodiment, a type of the conductive structure includes one of or a combination of a conductive pad, conductive foam, and conductive fabric.

In a possible embodiment, a width of the recess is in a range from 0.6 mm to 1.5 mm, and a height of the recess is in a range from 0.2 mm to 0.75 mm.

In a possible embodiment, a width of the conductive structure is in a range from 0.6 mm to 1.5 mm, and a height of the conductive structure is in a range from 0.6 mm to 1.7 mm.

According to a second aspect, this application provides an electronic device. The electronic device includes a housing and the foregoing circuit board assembly. The circuit board assembly is accommodated in the housing.

### BRIEF DESCRIPTION OF DRAWINGS

FIG. 1 is a schematic diagram of a structure of an electronic device according to an embodiment of this application;
FIG. 2 is a schematic exploded view of the electronic device shown in FIG. 1;
FIG. 3 is a schematic top view of a circuit board assembly shown in FIG. 2;
FIG. 4 is a schematic sectional view obtained by cutting along an A-A sectional line shown in FIG. 3;
FIG. 5 is a schematic sectional view obtained by cutting along a B-B sectional line shown in FIG. 3;
FIG. 6 is a schematic sectional view obtained by cutting along a C-C sectional line shown in FIG. 3;
FIG. 7 is another schematic sectional view obtained by cutting along a B-B sectional line shown in FIG. 3;
FIG. 8 is another schematic sectional view obtained by cutting along a C-C sectional line shown in FIG. 3;
FIG. 9 is a schematic assembly diagram of a conductive structure and a first solder pad shown in FIG. 7;
FIG. 10 is a schematic diagram of states of a conductive structure, a first solder pad, and a shielding cover shown in FIG. 7 during a reflow soldering process;
FIG. 11 is a schematic sectional view obtained by cutting along a D-D sectional line shown in FIG. 3;
FIG. 12 is a schematic side view of a shielding cover shown in FIG. 11;
FIG. 13 is another schematic sectional view obtained by cutting along a C-C sectional line shown in FIG. 3; and
FIG. 14 is a schematic diagram of a structure of a circuit board assembly according to another embodiment of this application.

### DESCRIPTION OF EMBODIMENTS

For ease of understanding, terms in embodiments of this application are first explained.

And/or: It is merely an association relationship for describing associated objects and represents that three relationships may exist. For example, A and/or B may represent the following three cases: only A exists, both A and B exist, and only B exists.

A plurality of: It means "two or more".

Connection: It should be understood in a broad sense. For example, if A is connected to B, A may be directly connected to B, or A and B may be indirectly connected via an intermediate medium.

The following clearly describes specific implementations of this application with reference to accompanying drawings.

Embodiments of this application provide a circuit board assembly and an electronic device. The electronic device may be but is not limited to a device such as a mobile phone, a tablet computer, an e-reader, a notebook computer, an in-vehicle device, a wearable device, or a wireless microwave receiving device.

A mobile phone, an electronic device that is widely used by a user in various application scenarios is used as an example for descriptions, but it may be understood that the mobile phone does not constitute a limitation.

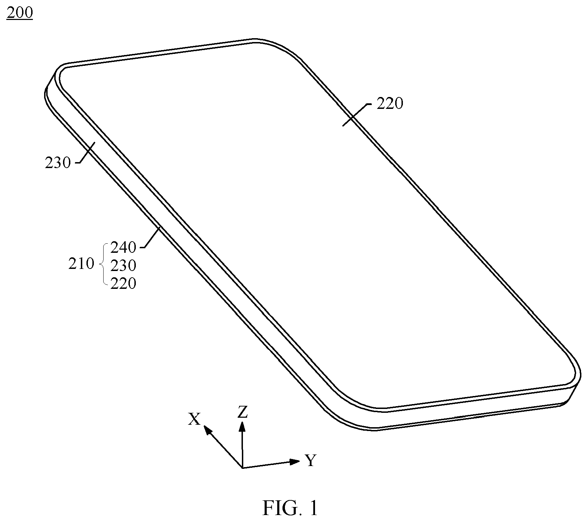

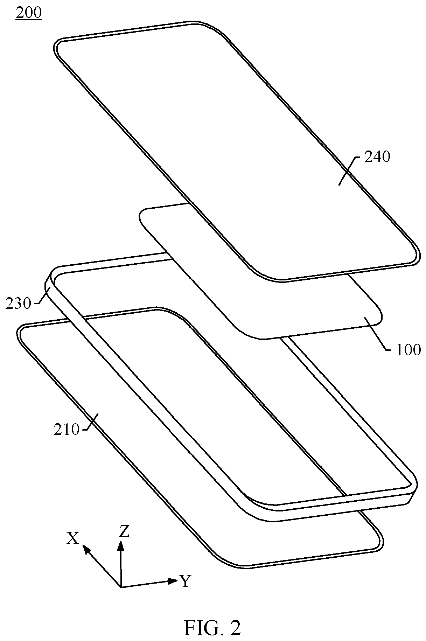

Refer to FIG. 1 and FIG. 2 together. FIG. 1 is a schematic diagram of a structure of an electronic device 200 according to an embodiment of this application, and FIG. 2 is a schematic exploded view of the electronic device 200 shown in FIG. 1.

In this embodiment of this application, for ease of description, a length direction of the electronic device 200 is a first direction X, a width direction of the electronic device 200 is a second direction Y, a height direction of the electronic device 200 is a third direction Z, and the first direction X, the second direction Y, and the third direction Z are perpendicular to each other. The electronic device 200 may include a housing 210 and a circuit board assembly 100. The circuit board assembly 100 is accommodated inside the housing 210 and can be protected from damage caused by external mechanical damage under protection of the housing 210.

The housing 210 may include a display module 220, a frame 230, and a rear cover 240. The display module 220 and the rear cover 240 are respectively connected to opposite sides of the frame 230. The display module 220 may be configured to display a text, an image, a video, and the like. The frame 230 serves as a structural bearing member of the electronic device 200 and is configured to mount the display module 220, the rear cover 240, and another component. When the electronic device 200 is a mobile phone, the frame 230 is a middle frame of the mobile phone, and the display module 220 is a cover plate facing the face of a user when the user holds the mobile phone. In this case, the display module 220 may be provided with a display screen to present an image, color, a text, and other visual information. The rear cover 240 is a cover plate facing away from the face of a user when the user holds the mobile phone. The rear cover 240 may be provided with a camera module as a rear camera to capture a still image or a dynamic video behind the mobile phone. For example, a material of the rear cover 240 includes glass, plastic, or ceramic.

The display module 220, the rear cover 240, and the frame 230 cooperate to define accommodating space of the electronic device 200. The accommodating space may accommodate the circuit board assembly 100, a battery, the camera module, and another component. The circuit board assembly 100 is located in the accommodating space. For example, as shown in FIG. 2, the circuit board assembly 100 is located between the frame 230 and the rear cover 240. The circuit board assembly 100 may be fixed to the frame 230, or the circuit board assembly 100 may be fixed to the rear cover 240.

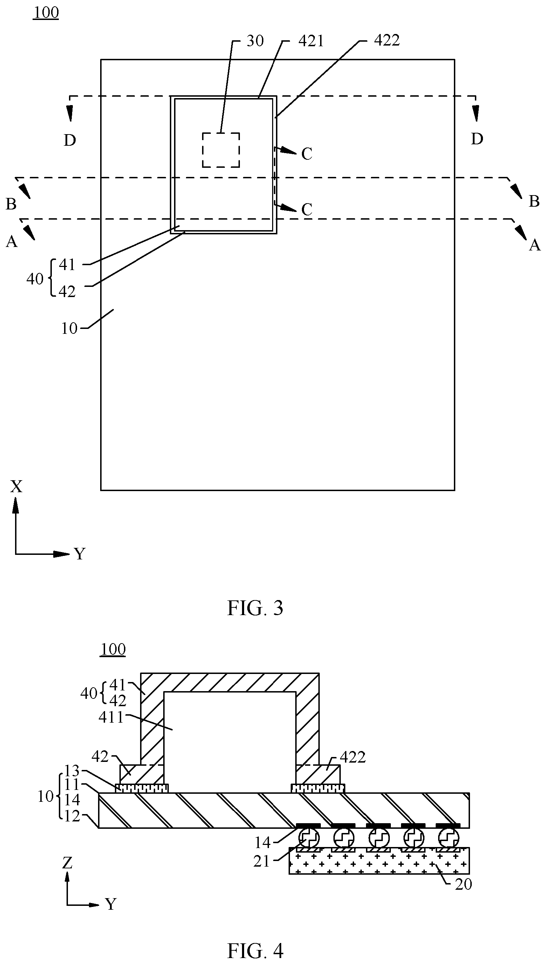

Refer to FIG. 3 and FIG. 4 together. FIG. 3 is a schematic top view of the circuit board assembly 100 shown in FIG. 2, and FIG. 4 is a schematic sectional view obtained by cutting along an A-A sectional line shown in FIG. 3.

The circuit board assembly 100 includes a circuit board 10, a chip 20, an electronic component 30, and a shielding cover 40. The electronic component 30 is disposed on the circuit board 10, and the shielding cover 40 covers a periphery of the electronic component 30 and is connected to the circuit board 10. The chip 20 is connected to the circuit board 10, and the chip 20 and the shielding cover 40 is respectively located on opposite sides of the circuit board 10. In other words, the chip 20 and the shielding cover 40 are disposed back-to-back. The circuit board 10 may be, but is not limited to, a printed circuit board, a flexible circuit board, or a rigid-flexible circuit board. The electronic component 30 may be a chip such as a CPU (Central Processing Unit, central processing unit), a GPU (Graphic Processing Unit, graphic processing unit), a TPU (Tensor Processing Unit, tensor processing unit), an AP (Application Processor, application processor), and an RFPA (Radio Frequency Power Amplifier, radio frequency power amplifier).

The circuit board 10 includes a first surface 11 and a second surface 12 that are disposed opposite to each other. The electronic component 30 and the shielding cover 40 are disposed on the first surface 11. A plurality of first solder pads 13 are disposed on the first surface 11, and the plurality of first solder pads 13 are spaced apart from each other. A first solder pad 13 may be a functional solder pad to achieve an electrical connection effect. For example, the first solder pad 13 may be configured to be electrically connected to the electronic component 30 or the shielding cover 40. Alternatively, a first solder pad 13 may be a non-functional solder pad to achieve an effect in mechanical fixing, support, and the like. The chip 20 is disposed on the second surface 12. A plurality of second solder pads 14 are disposed on the second surface 12, and the plurality of second solder pads 14 are spaced apart from each other. A second solder pad 14 may be a functional solder pad to achieve an electrical connection effect. For example, the second solder pad 14 may be configured to be electrically connected to the chip 20. A second solder pad 14 may alternatively be a non-functional solder pad to achieve an effect in mechanical fixing, support, and the like. The following describes an example in which the first solder pad 13 and the second solder pad 14 are functional pads.

The plurality of second solder pads 14 and the plurality of first solder pads 13 at least partially overlap in a height direction of the circuit board 10 (that is, the third direction Z). In this way, a solder pad of the shielding cover 40 and a solder pad of the chip 20 may be directly disposed back-to-back, so that the shielding cover 40 and the chip 20 can be disposed back-to-back.

The electronic component 30 is disposed on the first surface 11, and the shielding cover 40 is also disposed on the first surface 11 and covers the periphery of the electronic component 30. The chip 20 is disposed on the second surface 12, and the chip 20 may be a chip 20 with a BGA (Ball Grid Array, ball grid array) solder ball 21. It may be understood that the electronic component 30 is a source of electromagnetic interference (electromagnetic interference, EMI). The shielding cover 40 is disposed at the periphery of the electronic component 30 to cover the electronic component 30, so that electromagnetic interference of the electronic component 30 can be shielded, thereby achieving good electromagnetic shielding performance and facilitating working performance of the electronic device 200.

It should be noted that a component disposed on the circuit board 10 are not limited to the foregoing component. The component may alternatively be another component such as a capacitor, an inductor, or a heat sink that can achieve functions such as electrical connection, protection, support, heat dissipation, and assembly. There may be one or more electronic components 30 and shielding covers 40 as needed. The following only uses a structure of one shielding cover 40 as an example to describe a structure of the shielding cover 40 in detail. Any improvement in the structure of one shielding cover 40 may be applied to another shielding cover 40 in a case of no conflict.

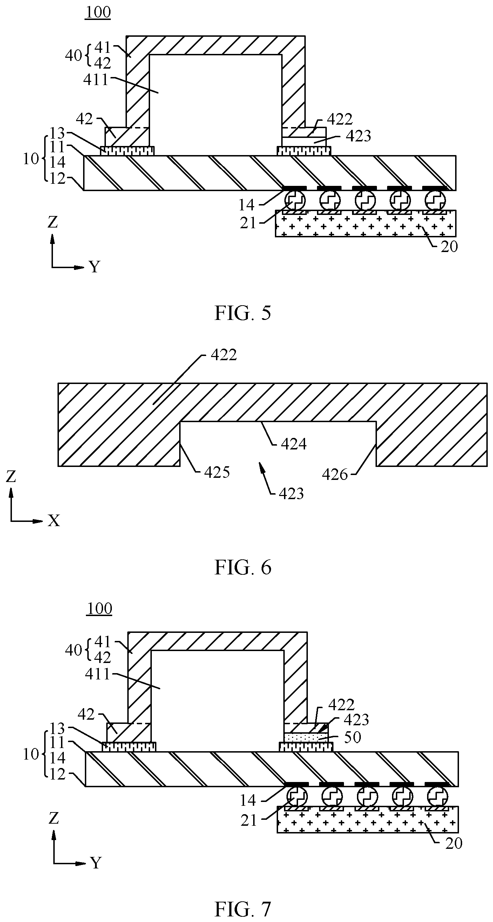

Refer to FIG. 3, FIG. 5, and FIG. 6 together. FIG. 5 is a schematic sectional view obtained by cutting along a B-B sectional line shown in FIG. 3, and FIG. 6 is a schematic sectional view obtained by cutting along a C-C sectional line shown in FIG. 3. The shielding cover 40 includes a main body 41 and a flange 42.

The main body 41 is in a shape of an inverted frame, and the main body 41 defines accommodation space 411. The accommodation space 411 provides accommodating space for the electronic component 30 and electromagnetic shielding space for the electronic component 30. The flange 42 is connected to one end of the main body 41 in a peripheral direction of the main body 41, and an angle is formed between the flange 42 and the main body 41. The angle between the flange 42 and the main body 41 may be selected arbitrarily based on satisfying operating reliability of the shielding cover 40. This is not strictly limited in embodiments of this application. For example, the angle between the flange 42 and the main body 41 may be 90° (falling within an allowable tolerance range). The flange 42 is also connected to the first surface 11 of the circuit board 10. Specifically, the flange 42 may be connected to the first solder pad 13 disposed on the first surface 11. The flange 42 is disposed to provide a sufficient contact area between the shielding cover 40 and the circuit board 10, to achieve a good fixing effect.

Refer to FIG. 3. The flange 42 may include two first side edges 421 and two second side edges 422. The two first side edges 421 are arranged opposite to each other in the first direction X, and the two second side edges 422 are arranged opposite to each other in the second direction Y. The two second side edges 422 are connected between the two first side edges 421. A recess 423 is provided on a surface of the flange 42 facing the first surface 11. The recess 423 runs through the flange 42 in a width direction of the flange 42 (that is, the second direction Y) and is communicated with the accommodation space 411. The recess 423 may be located on any one, two, three, or four of the two first side edges 421 and the two second side edges 422. There may be one or more recesses 423 as needed. When there are a plurality of recesses 423, the plurality of recesses 423 are spaced apart from each other. The following uses only one recess 423 and the recess 423 being located on one second side edge 422 of the two second side edges 422 as an example to describe a structure of the recess 423 in detail. Any improvement in a structure of one second side edge 422 of the two second side edges 422 may be applied to another edge of the flange 42 in a case of no conflict.

Refer to FIG. 5 and FIG. 6 together. The recess 423 is provided on one second side edge 422 of the two second side edges 422, and orthographic projection of the recess 423 on the circuit board 10 at least partially falls within an orthographic projection range of the chip 20 on the circuit board 10. The recess 423 includes a top wall 424, a first side wall 425, and a second side wall 426. The top wall 424 is a wall in the recess 423 that is disposed opposite to the first surface 11 of the circuit board 10. The first side wall 425 and the second side wall 426 are disposed opposite to each other. The top wall 424 is connected between the first side wall 425 and the second side wall 426.

In a possible implementation, a width of the recess 423 may be in a range from 0.6 mm to 1.5 mm (including end values 0.6 mm and 1.5 mm), and the width of the recess 423 is a size of the recess 423 in the second direction Y. A height of the recess 423 may be in a range from 0.2 mm to 0.75 mm (including end values 0.2 mm and 0.75 mm), and the height of the recess 423 is a size of the recess 423 in the third direction Z.

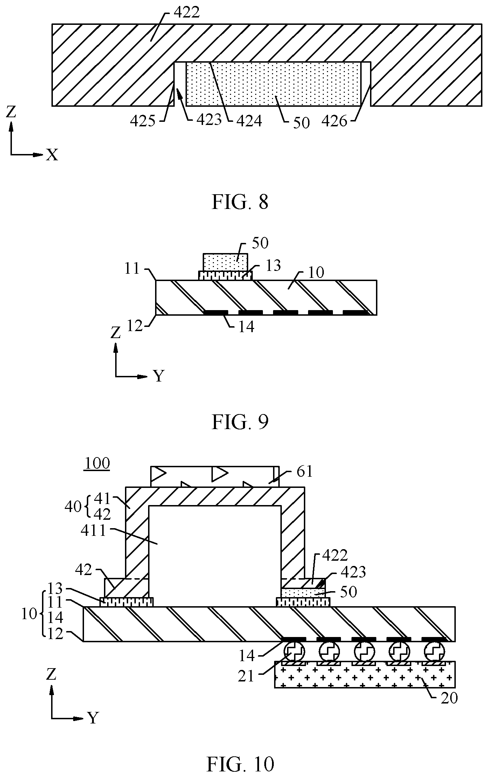

Refer to FIG. 7 and FIG. 8 together. FIG. 7 is another schematic sectional view obtained by cutting along a B-B sectional line shown in FIG. 3, and FIG. 8 is another schematic sectional view obtained by cutting along a C-C sectional line shown in FIG. 3. According to the invention, the circuit board assembly 100 further includes a conductive structure 50. The conductive structure 50 is located in the recess 423 and connected between the top wall 424 of the recess 423 and the first surface 11. Orthographic projection of the conductive structure 50 on the circuit board 10 at least partially falls within the orthographic projection range of the chip 20 on the circuit board 10. Specifically, the conductive structure 50 is connected between the flange 42 and the first solder pad 13 to implement physical and electrical connections between the shielding cover 40 and the circuit board 10 via the conductive structure 50.

It may be understood that with a development trend of high density of a device layout on the circuit board 10, there may be a scenario in which the chip 20 and the shielding cover 40 are disposed back-to-back. In this scenario, when it is necessary to perform maintenance operations such as disassembly and welding on the shielding cover 40 for repairing and diagnosing a component in the shielding cover 40, because the shielding cover 40 is directly attached to the chip 20 back-to-back, problems such as chip 20 failure due to adhesive explosion and increased stress on a solder joint of the chip 20 may easily occur. This further increases a risk of failure of the circuit board assembly 100 and worsens maintainability and operating reliability of the circuit board assembly 100.

Therefore, the recess 423 is provided in a part where the conductive cover is attached to the chip 20 back-to-back, and the conductive structure 50 is located in the recess 423 and connected between the conductive cover and the circuit board 10. The conductive structure 50 may be located at a position where the shielding cover 40 is attached to the chip 20 back-to-back, so that when the shielding cover 40 is repaired, the shielding cover 40 may not be directly attached to the chip 20 back-to-back due to a presence of the conductive structure 50. When the shielding cover 40 is repaired, there is no need to heat the part where the shielding cover 40 is attached to the chip 20 back-to-back, so that the chip 20 may not be directly heated, and the risk of the adhesive explosion of the chip 20 is low. In addition, the conductive structure 50 may be located at the position where the shielding cover 40 is attached to the chip 20 back-to-back, and the conductive structure 50 is attached to the chip 20 back-to-back due to the presence of the conductive structure 50. A stress on the shielding cover 40 during the maintenance operation can be absorbed by the conductive structure 50 and a stress on the solder joint of the chip 20 is reduced. Moreover, a part of the structure of the shielding cover 40 is replaced with the conductive structure 50, still ensuring a shielding effect and performance of the shielding cover 40, and the maintainability and operating reliability of the circuit board assembly 100 are better.

**In** this embodiment of this application, the conductive structure 50 is a conductive material having compression performance. For example, a type of the conductive structure 50 includes one of or a combination of a conductive pad, conductive foam, and conductive fabric. A compression amount of the conductive structure 50 may be around 50% (falling within an allowable tolerance range).

**In** a possible implementation, a width of the conductive structure 50 may be in a range from 0.6 mm to 1.5 mm (including end values 0.6 mm and 1.5 mm), and the width of the conductive structure 50 is a size of the conductive structure 50 in the second direction Y. A height of the conductive structure 50 may be in a range from 0.6 mm to 1.7 mm (including end values 0.6 mm and 1.7 mm), and the height of the conductive structure 50 is a size of the conductive structure 50 in the third direction Z. It should be understood that the width and height of the conductive structure 50 may be related to the width and height of the recess 423. For example, if the width of the recess 423 is W mm and the height is H mm, the width of the conductive structure 50 may be the same as the width of the recess 423 and is also W mm, and the height of the conductive structure 50 may be 2H+0.2 mm.

In this embodiment of this application, the conductive structure 50 may include a compressed state and a natural state.

When the conductive structure 50 is in the natural state, the conductive structure 50 may be connected to the shielding cover 40 and separated from the circuit board 10, so that the shielding cover 40 and the conductive structure 50 are combined together and fed as a whole, so as to be connected together to the first solder pad 13 on the first surface 11. Specifically, the conductive structure 50 may be connected to the top wall 424 of the recess 423. For example, the conductive structure 50 may be adhered on the top wall 424 of the recess 423.

Alternatively, refer to FIG. 9, which relates to an embodiment not covered by the claimed invention. FIG. 9 is a schematic assembly diagram of the conductive structure 50 and the first solder pad 13 shown in FIG. 7. When the conductive structure 50 is in the natural state, the conductive structure 50 may be connected to the circuit board 10 and separated from the shielding cover 40, so that the conductive structure 50 and the shielding cover 40 are two parts and are respectively connected to the first solder pads 13 on the first surface 11. For example, the conductive structure 50 may be welded or adhered to the first solder pad 13 of the circuit board 10.

When the conductive structure 50 is in the compressed state, the conductive structure 50 is connected between the shielding cover 40 and the circuit board 10. Specifically, the conductive structure 50 is connected between the top wall 424 of the recess 423 and the first solder pad 13. In an example not covered by the claimed invention, the conductive structure 50 is adhered on the top wall 424 of the recess 423 and welded to the first solder pad 13. Specifically, refer to FIG. 10. FIG. 10 is a schematic diagram of states of the conductive structure 50, the first solder pad 13, and the shielding cover 40 shown in FIG. 7 during a reflow soldering process. The conductive structure 50 may be welded to the first solder pad 13 of the circuit board 10 first, and then the shielding cover 40 is welded to the circuit board 10. Alternatively, in a further example not covered by the claimed invention, the conductive structure 50 may be adhered to the recess 423 of the shielding cover 40 first, and then the shielding cover 40 with the conductive structure 50 adhered is welded to the first solder pad 13 of the circuit board 10. In both of the foregoing methods, the conductive structure 50 may be in contact via the flange 42 of the shielding cover 40. During the reflow soldering process, an auxiliary structure 61 may also be added and pressed against the main body 41 of the shielding cover 40 to avoid a problem of false welding caused by expansion of the conductive structure 50.

Refer to FIG. 7 and FIG. 8 together. When the conductive structure 50 is connected between the shielding cover 40 and the circuit board 10, the conductive structure 50 is located in the recess 423. The conductive structure 50 is in contact with the top wall 424 of the recess 423 and the first solder pad 13. Both ends of the conductive structure 50 are spaced apart from the first side wall 425 of the recess 423 and the second side wall 426 of the recess 423 respectively. It may be understood that the conductive structure 50 is spaced apart from both the first side wall 425 and the second side wall 426, and a gap may be left so that the gap may be used as expansion space for the conductive structure 50 to expand, thereby effectively avoiding the problem of false welding between the shielding cover 40 and the circuit board 10 due to the expansion of the conductive structure 50, and achieving good reliability.

For example, distances/a distance between the conductive structure 50 and the first side wall 425 and/or the second side wall 426 are/is in a range from 0.2 mm to 0.5 mm (including end values 0.2 mm and 0.5 mm). The conductive structure 50 may be a structure with six sides wrapped by a conductive material. Alternatively, the conductive structure 50 may be a structure in which two opposite end surfaces are not wrapped by a conductive material, and a peripheral side connected between the two end surfaces is wrapped by a conductive material. In this way, the two end surfaces of the conductive structure 50 that are not wrapped by the conductive material may be disposed opposite to the first side wall 425 and the second side wall 426 respectively.

In a possible implementation not covered by the claimed invention, a part of the shielding cover 40 with the recess 423 and the conductive structure 50 may be the same as a part of the shielding cover 40 without the recess 423 and the conductive structure 50, and both use a soldering material to weld the conductive structure 50 to the first solder pad 13 on the first surface 11. For example, the soldering material may be solder.

According to the invention, the part of the shielding cover 40 without the recess 423 and the conductive structure 50 uses the soldering material, so that the flange 42 is welded to the first solder pad 13 on the first surface 11. The part of the shielding cover 40 with the recess 423 and the conductive structure 50 may not use the soldering material, but the conductive structure 50 is in contact with the first solder pad 13 on the first surface 11, and the conductive structure 50 is pressed against the first solder pad 13 by an external structural member located on a side of the flange 42 facing away from the circuit board 10. The conductive structure 50 electrically connects the circuit board 10 and the shielding cover 40 under a pressure exerted by the external structural member, thereby achieving the shielding effect and performance of the shielding cover 40. In this way, because the part where the shielding cover 40 is attached to the chip 20 back-to-back is not welded with a soldering material, there is no need to heat the first solder pad 13 and the second solder pad 14 of corresponding parts of the chip 20 when the shielding cover 40 is repaired, so that the chip 20 may not be directly heated, and the risk of adhesive explosion of the chip 20 is low. In addition, the stress on the shielding cover 40 is absorbed by the conductive structure 50, and the stress on the solder joint of the chip 20 is reduced.

In this embodiment of this application, the conductive structure 50 is spaced apart from the electronic component 30. In this way, a short circuit problem caused by collision between the conductive structure 50 and the electronic component 30 located inside the accommodation space 411 can be avoided, and the circuit board assembly 100 has good operating reliability. For example, a distance between the conductive structure 50 and the electronic component 30 is in a range from 0.3 mm to 0.5 mm (including end values 0.3 mm and 0.5 mm).

In a possible implementation, a length of the recess 423 may be less than a length of the main body 41, and a length of the conductive structure 50 may be less than the length of the main body 41. A length is a size in the first direction X. In this way, a part of one edge of the flange 42 may be replaced with the conductive structure 50, and other parts of the edge are still made of a material of the shielding cover 40.

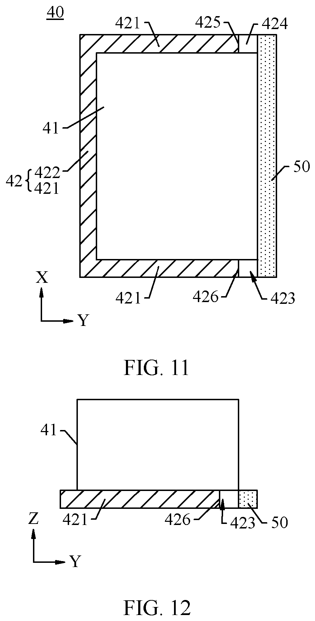

In another possible implementation, refer to FIG. 11 and FIG. 12 together. FIG. 11 is a schematic sectional view obtained by cutting along a D-D sectional line shown in FIG. 3, and FIG. 12 is a schematic side view of the shielding cover 40 shown in FIG. 11. In this embodiment, the top wall 424 of the recess 423 is located on two first side edges 421 and one second side edge 422, and the first side wall 425 of the recess 423 and the second side wall 426 of the recess 423 are respectively located on the two first side edges 421. The length of the recess 423 may be equal to the length of the main body 41, and the length of the conductive structure 50 may be equal to the length of the main body 41. The length is the size in the first direction X. In this way, almost all of one edge of the flange 42 may be replaced with the conductive structure 50, and other edges of the flange 42 are still made of the material of the shielding cover 40. In addition, the other edges in the flange 42 may be spaced apart from the edge made of the conductive structure 50, to provide the expansion space for the conductive structure 50.

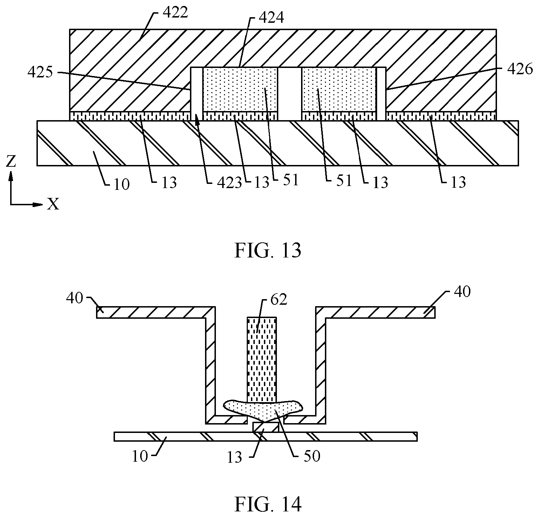

In this embodiment of this application, refer to FIG. 13. FIG. 13 is another schematic sectional view obtained by cutting along a C-C sectional line shown in FIG. 3. The conductive structure 50 may include a plurality of substructures 51 the plurality of substructures 51 are spaced apart from each other, and each substructure 51 is connected between the top wall 424 of the recess 423 and the first surface 11. In this way, the conductive structure 50 may be designed into a plurality of small sections to fully consider a spacing between two adjacent first solder pads 13 and a requirement for electromagnetic shielding, to facilitate further expanding a size of the shielding cover 40. In addition, based on a contact form in which the shielding cover 40 is in contact with the first solder pad 13 via the substructure 51, a problem of poor welding between the shielding cover 40 and the first solder pad 13 can be resolved, coplanarity between the shielding cover 40 and the first solder pad 13 can be ensured, and a thickness of the circuit board assembly 100 can be reduced to a certain extent. For example, a distance between two adjacent substructures 51 is less than or equal to 1.2 mm.

In a possible implementation, the flange 42 is an irregular special-shaped flange. The conductive structure 50 may include an inner core and a conductive outer layer wrapping the inner core. To match the special-shaped flange, the inner core may be cut without cutting the conductive outer layer, so that the cut inner core and the continuous conductive outer layer can adapt to the special-shaped flange and have bendability. Moreover, based on the bendability, the conductive structure 50 can also be electrically connected between the shielding cover 40 and the circuit board 10 to ensure the shielding effect of the shielding cover 40.

Refer to FIG. 14. FIG. 14 is a schematic diagram of a structure of a circuit board assembly 100 according to another embodiment of this application, said embodiment not being covered by the claimed invention. In another embodiment of this application, parts of two adjacent shielding covers 40 that are not attached to a chip 20 back-to-back may be welded on a first solder pad 13 first, and parts of the two adjacent shielding covers 40 that are attached to the chip 20 back-to-back may be welded to the first solder pad 13 without using a soldering material. A conductive structure 50 may be connected between two adjacent shielding covers 40, and the conductive structure 50, the shielding cover 40, and the first solder pad 13 may be closely connected together via a structural member 62 such as a middle frame or a support, so that the shielding cover 40 can achieve a shielding effect.

## Claims

1. A circuit board assembly (100), comprising:
a circuit board (10), wherein the circuit board (10) comprises a first surface (11) and a second surface (12) that are disposed opposite to each other;
a plurality of first solder pads (13) that are disposed on the first surface (11) and are spaced apart from each other;
a chip (20), wherein the chip (20) is disposed on the second surface (12);
an electronic component (30), wherein the electronic component (30) is disposed on the first surface (11);
a shielding cover (40), wherein the shielding cover (40) comprises a main body (41) and a flange (42), the main body (41) defines accommodation space (411) in which the electronic component (30) is located, the flange (42) is connected to one end of the main body (41) in a peripheral direction of the main body (41), an angle is formed between the flange (42) and the main body (41), the shielding cover (40) is configured to cover a periphery of the electronic component (30) so as to shield the electromagnetic interference of the electronic component (30), a recess (423) is provided on a surface of the flange (42) facing the first surface (11), the recess (423) runs through the flange (42) in a width direction of the flange (42) and is communicated with the accommodation space, the recess (423) comprises a top wall (424), a first side wall (425) and a second side wall (426), and the top wall (424) is connected between the first side wall (425) and the second side wall (426); and
a conductive structure (50), wherein the conductive structure (50) is located in the recess (423) and connected between the top wall (424) and the first surface (11), orthographic projection of the conductive structure (50) on the circuit board (10) at least partially falls within an orthographic projection range of the chip (20) on the circuit board, the conductive structure (50) is electrically connected to a first solder pad (13), and a part of the flange (42) that is provided with the recess (423) and the conductive structure (50) is not welded to the first solder pad (13) electrically connected to the conductive structure (50) using soldering material, but the conductive structure (50) is pressed against the first solder pad (13) electrically connected to the conductive structure (50) by an external structural member located on a side of the flange (42) facing away from the circuit board (10), and a part of the flange (42) that is not provided with the recess (423) and the conductive structure (50) is welded to another first solder pad (13) using soldering material.

2. The circuit board assembly (100) according to claim 1, wherein the conductive structure (50) is made of a conductive material with compression performance; wherein
the conductive material is in the compressed state, when the conductive structure (50) is connected between the shielding cover (40) and the circuit board (10); and
the conductive material is in the natural state, when the conductive structure (50) is connected to the shielding cover (40) and separated from the circuit board (10), or when the conductive structure (50) is connected to the circuit board (10) and separated from the shielding cover (40).

3. The circuit board assembly (100) according to any one of claims 1 to 2, wherein the conductive structure (50) is in contact with the top wall (424), and the conductive structure (50) is spaced apart from both the first side wall (425) and the second side wall (426).

4. The circuit board assembly (100) according to claim 3, wherein distances/a distance between the conductive structure (50) and the first side wall (425) and/or the second side wall (426) are/is in a range from 0.2 mm to 0.5 mm.

5. The circuit board assembly (100) according to any one of claims 1 to 2, wherein the first solder pad (13) electrically connected to the conductive structure (50) is in contact with the conductive structure (50), or the first solder pad (13) electrically connected to the conductive structure (50) and the conductive structure (50) are connected using solder material.

6. The circuit board assembly (100) according to any one of claims 1 to 2, wherein the conductive structure (50) is spaced apart from the electronic component (30).

7. The circuit board assembly (100) according to claim 6, wherein a spacing between the conductive structure (50) and the electronic component (30) is in a range from 0.3 mm to 0.5 mm.

8. The circuit board assembly (100) according to any one of claims 1 to 2, wherein a length of the conductive structure (50) is less than or equal to a length of the main body (41).

9. The circuit board assembly (100) according to any one of claims 1 to 2, wherein the conductive structure (50) comprises a plurality of substructures (51), the plurality of substructures (51) are spaced apart from each other, each substructure (51) is connected between the top wall (424) of the recess (423) and the first surface (11), and a distance between two adjacent substructures is less than or equal to 1.2 mm.

10. The circuit board assembly (100) according to any one of claims 1 to 2, wherein a type of the conductive structure (50) comprises one of or a combination of a conductive pad, conductive foam, and conductive fabric.

11. The circuit board assembly (100) according to any one of claims 1 to 2, wherein a width of the recess (423) is in a range from 0.6 mm to 1.5 mm, and a height of the recess (423) is in a range from 0.2 mm to 0.75 mm.

12. The circuit board assembly (100) according to any one of claims 1 to 2, wherein a width of the conductive structure (50) is in a range from 0.6 mm to 1.5 mm, and a height of the conductive structure (50) is in a range from 0.6 mm to 1.7 mm.

13. An electronic device (200), wherein the electronic device (200) comprises a housing (210) and the circuit board assembly (100) according to any one of claims 1 to 12, and the circuit board assembly (100) is accommodated in the housing (210).

## Patentansprüche

1. Leiterplattenanordnung (100), umfassend:
eine Leiterplatte (10), wobei die Leiterplatte (10) eine erste Oberfläche (11) und eine zweite Oberfläche (12) umfasst, die einander gegenüberliegend angeordnet sind;
eine Vielzahl von ersten Lötpads (13), die auf der ersten Oberfläche (11) angeordnet und voneinander beabstandet sind;
einen Chip (20), wobei der Chip (20) auf der zweiten Oberfläche (12) angeordnet ist;
eine elektronische Komponente (30), wobei die elektronische Komponente (30) auf der ersten Oberfläche (11) angeordnet ist;
eine Abschirmkappe (40), wobei die Abschirmkappe (40) einen Hauptkörper (41) und einen Flansch (42) umfasst, der Hauptkörper (41) einen Aufnahmeraum (411) definiert, in dem sich die elektronische Komponente (30) befindet, der Flansch (42) mit einem Ende des Hauptkörpers (41) in einer Umfangsrichtung des Hauptkörpers (41) verbunden ist, ein Winkel zwischen dem Flansch (42) und dem Hauptkörper (41) gebildet ist, die Abschirmkappe (40) dazu konfiguriert ist, einen Umfang der elektronischen Komponente (30) abzudecken, um die elektromagnetische Interferenz der elektronischen Komponente (30) abzuschirmen, eine Ausnehmung (423) auf einer der ersten Oberfläche (11) zugewandten Seite des Flansches (42) vorgesehen ist, die Ausnehmung (423) den Flansch (42) in einer Breitenrichtung des Flansches (42) durchsetzt und mit dem Aufnahmeraum in Verbindung steht, die Ausnehmung (423) eine obere Wand (424), eine erste Seitenwand (425) und eine zweite Seitenwand (426) umfasst, und die obere Wand (424) zwischen der ersten Seitenwand (425) und der zweiten Seitenwand (426) verbunden ist; und
eine leitfähige Struktur (50), wobei die leitfähige Struktur (50) in der Ausnehmung (423) angeordnet und zwischen der oberen Wand (424) und der ersten Oberfläche (11) verbunden ist, eine orthogonale Projektion der leitfähigen Struktur (50) auf die Leiterplatte (10) zumindest teilweise innerhalb eines orthogonalen Projektionsbereichs des Chips (20) auf die Leiterplatte fällt, die leitfähige Struktur (50) elektrisch mit einem ersten Lötpad (13) verbunden ist, und ein Teil des Flansches (42), der mit der Ausnehmung (423) und der leitfähigen Struktur (50) versehen ist, nicht unter Verwendung von Lötmaterial mit dem ersten Lötpad (13), das elektrisch mit der leitfähigen Struktur (50) verbunden ist, verlötet ist, sondern die leitfähige Struktur (50) durch ein externes strukturelles Element, das sich auf einer von der Leiterplatte (10) abgewandten Seite des Flansches (42) befindet, gegen das erste Lötpad (13) gedrückt wird, das elektrisch mit der leitfähigen Struktur (50) verbunden ist, und ein Teil des Flansches (42), der nicht mit der Ausnehmung (423) und der leitfähigen Struktur (50) versehen ist, unter Verwendung von Lötmaterial mit einem weiteren ersten Lötpad (13) verlötet ist.

2. Leiterplattenanordnung (100) nach Anspruch 1, wobei die leitfähige Struktur (50) aus einem leitfähigen Material mit Kompressionseigenschaften besteht; wobei
das leitfähige Material befindet sich im komprimierten Zustand, wenn die leitfähige Struktur (50) zwischen der Abschirmabdeckung (40) und der Leiterplatte (10) verbunden ist; und
das leitfähige Material befindet sich im natürlichen Zustand, wenn die leitfähige Struktur (50) mit der Abschirmabdeckung (40) verbunden und von der Leiterplatte (10) getrennt ist, oder wenn die leitfähige Struktur (50) mit der Leiterplatte (10) verbunden und von der Abschirmabdeckung (40) getrennt ist.

3. Leiterplattenanordnung (100) nach einem der Ansprüche 1 bis 2, wobei die leitfähige Struktur (50) in Kontakt mit der oberen Wand (424) steht und die leitfähige Struktur (50) sowohl von der ersten Seitenwand (425) als auch von der zweiten Seitenwand (426) beabstandet ist.

4. Leiterplattenanordnung (100) nach Anspruch 3, wobei ein Abstand/Abstände zwischen der leitfähigen Struktur (50) und der ersten Seitenwand (425) und/oder der zweiten Seitenwand (426) in einem Bereich von 0,2 mm bis 0,5 mm liegt/liegen.

5. Leiterplattenanordnung (100) nach einem der Ansprüche 1 bis 2, wobei das erste Lötpad (13), das elektrisch mit der leitfähigen Struktur (50) verbunden ist, in Kontakt mit der leitfähigen Struktur (50) steht, oder das erste Lötpad (13), das elektrisch mit der leitfähigen Struktur (50) verbunden ist, und die leitfähige Struktur (50) unter Verwendung von Lötmaterial verbunden sind.

6. Leiterplattenanordnung (100) nach einem der Ansprüche 1 bis 2, wobei die leitfähige Struktur (50) von dem elektronischen Bauteil (30) beabstandet ist.

7. Leiterplattenanordnung (100) nach Anspruch 6, wobei ein Abstand zwischen der leitfähigen Struktur (50) und dem elektronischen Bauteil (30) in einem Bereich von 0,3 mm bis 0,5 mm liegt.

8. Leiterplattenanordnung (100) nach einem der Ansprüche 1 bis 2, wobei eine Länge der leitfähigen Struktur (50) kleiner oder gleich einer Länge des Hauptkörpers (41) ist.

9. Leiterplattenanordnung (100) nach einem der Ansprüche 1 bis 2, wobei die leitfähige Struktur (50) eine Mehrzahl von Unterstrukturen (51) umfasst, die Mehrzahl von Unterstrukturen (51) voneinander beabstandet ist, jede Unterstruktur (51) zwischen der oberen Wand (424) der Ausnehmung (423) und der ersten Oberfläche (11) verbunden ist und ein Abstand zwischen zwei benachbarten Unterstrukturen kleiner oder gleich 1,2 mm ist.

10. Leiterplattenanordnung (100) nach einem der Ansprüche 1 bis 2, wobei ein Typ der leitfähigen Struktur (50) eines oder eine Kombination aus einem leitfähigen Pad, leitfähigem Schaumstoff und leitfähigem Gewebe umfasst.

11. Leiterplattenanordnung (100) nach einem der Ansprüche 1 bis 2, wobei eine Breite der Ausnehmung (423) in einem Bereich von 0,6 mm bis 1,5 mm liegt und eine Höhe der Ausnehmung (423) in einem Bereich von 0,2 mm bis 0,75 mm liegt.

12. Die Leiterplattenbaugruppe (100) nach einem der Ansprüche 1 bis 2, wobei eine Breite der leitfähigen Struktur (50) in einem Bereich von 0,6 mm bis 1,5 mm liegt und eine Höhe der leitfähigen Struktur (50) in einem Bereich von 0,6 mm bis 1,7 mm liegt.

13. Elektronische Vorrichtung (200), wobei die elektronische Vorrichtung (200) ein Gehäuse (210) und die Leiterplattenbaugruppe (100) nach einem der Ansprüche 1 bis 12 umfasst, und die Leiterplattenbaugruppe (100) in dem Gehäuse (210) untergebracht ist.

## Revendications

1. Un ensemble de carte de circuit imprimé (100), comprenant :
une carte de circuit imprimé (10), dans laquelle la carte de circuit imprimé (10) comprend une première surface (11) et une seconde surface (12) qui sont disposées à l'opposé l'une de l'autre ;
une pluralité de premiers plots de soudure (13) qui sont disposés sur la première surface (11) et sont espacés les uns des autres ;
une puce (20), dans laquelle la puce (20) est disposée sur la seconde surface (12) ;
un composant électronique (30), dans lequel le composant électronique (30) est disposé sur la première surface (11) ;
un couvercle de blindage (40), dans lequel le couvercle de blindage (40) comprend un corps principal (41) et une collerette (42), le corps principal (41) définit un espace de logement (411) dans lequel est situé le composant électronique (30), la collerette (42) est reliée à une extrémité du corps principal (41) dans une direction périphérique du corps principal (41), un angle est formé entre la collerette (42) et le corps principal (41), le couvercle de blindage (40) est configuré pour recouvrir une périphérie du composant électronique (30) afin de blinder les interférences électromagnétiques du composant électronique (30), un évidement (423) est prévu sur une surface de la collerette (42) faisant face à la première surface (11), l'évidement (423) s'étend à travers la collerette (42) dans une direction de largeur de la collerette (42) et est en communication avec l'espace de logement, l'évidement (423) comprend une paroi supérieure (424), une première paroi latérale (425) et une seconde paroi latérale (426), et la paroi supérieure (424) est reliée entre la première paroi latérale (425) et la seconde paroi latérale (426) ; et
une structure conductrice (50), dans laquelle la structure conductrice (50) est située dans l'évidement (423) et reliée entre la paroi supérieure (424) et la première surface (11), la projection orthogonale de la structure conductrice (50) sur la carte de circuit imprimé (10) tombe au moins partiellement dans une plage de projection orthogonale de la puce (20) sur la carte de circuit imprimé, la structure conductrice (50) est électriquement connectée à un premier plot de soudure (13), et une partie de la collerette (42) qui est pourvue de l'évidement (423) et de la structure conductrice (50) n'est pas soudée au premier plot de soudure (13) électriquement connecté à la structure conductrice (50) en utilisant un matériau de soudure, mais la structure conductrice (50) est pressée contre le premier plot de soudure (13) électriquement connecté à la structure conductrice (50) par un élément structurel externe situé sur un côté de la collerette (42) opposé à la carte de circuit imprimé (10), et une partie de la collerette (42) qui n'est pas pourvue de l'évidement (423) et de la structure conductrice (50) est soudée à un autre premier plot de soudure (13) en utilisant un matériau de soudure.

2. L'ensemble de carte de circuit imprimé (100) selon la revendication 1, dans lequel la structure conductrice (50) est faite d'un matériau conducteur présentant des propriétés de compression ; dans lequel
le matériau conducteur est dans l'état comprimé, lorsque la structure conductrice (50) est connectée entre le couvercle de blindage (40) et la carte de circuit imprimé (10) ; et
le matériau conducteur est dans l'état naturel, lorsque la structure conductrice (50) est connectée au couvercle de blindage (40) et séparée de la carte de circuit imprimé (10), ou lorsque la structure conductrice (50) est connectée à la carte de circuit imprimé (10) et séparée du couvercle de blindage (40).

3. L'assemblage de carte de circuit imprimé (100) selon l'une quelconque des revendications 1 à 2, dans lequel la structure conductrice (50) est en contact avec la paroi supérieure (424), et la structure conductrice (50) est espacée à la fois de la première paroi latérale (425) et de la seconde paroi latérale (426).

4. L'assemblage de carte de circuit imprimé (100) selon la revendication 3, dans lequel la ou les distances entre la structure conductrice (50) et la première paroi latérale (425) et/ou la seconde paroi latérale (426) sont dans une plage allant de 0,2 mm à 0,5 mm.

5. L'assemblage de carte de circuit imprimé (100) selon l'une quelconque des revendications 1 à 2, dans lequel le premier plot de soudure (13) connecté électriquement à la structure conductrice (50) est en contact avec la structure conductrice (50), ou le premier plot de soudure (13) connecté électriquement à la structure conductrice (50) et la structure conductrice (50) sont connectés à l'aide d'un matériau de soudure.

6. L'assemblage de carte de circuit imprimé (100) selon l'une quelconque des revendications 1 à 2, dans lequel la structure conductrice (50) est espacée du composant électronique (30).

7. L'assemblage de carte de circuit imprimé (100) selon la revendication 6, dans lequel un espacement entre la structure conductrice (50) et le composant électronique (30) est dans une plage allant de 0,3 mm à 0,5 mm.

8. L'assemblage de carte de circuit imprimé (100) selon l'une quelconque des revendications 1 à 2, dans lequel une longueur de la structure conductrice (50) est inférieure ou égale à une longueur du corps principal (41).

9. L'assemblage de carte de circuit imprimé (100) selon l'une quelconque des revendications 1 à 2, dans lequel la structure conductrice (50) comprend une pluralité de sous-structures (51), la pluralité de sous-structures (51) sont espacées les unes des autres, chaque sous-structure (51) est connectée entre la paroi supérieure (424) du renfoncement (423) et la première surface (11), et une distance entre deux sous-structures adjacentes est inférieure ou égale à 1,2 mm.

10. L'assemblage de carte de circuit imprimé (100) selon l'une quelconque des revendications 1 à 2, dans lequel un type de structure conductrice (50) comprend l'un ou une combinaison d'un plot conducteur, d'une mousse conductrice et d'un tissu conducteur.

11. L'assemblage de carte de circuit imprimé (100) selon l'une quelconque des revendications 1 à 2, dans lequel une largeur du renfoncement (423) est dans une plage allant de 0,6 mm à 1,5 mm, et une hauteur du renfoncement (423) est dans une plage allant de 0,2 mm à 0,75 mm.

12. L'assemblage de carte de circuit imprimé (100) selon l'une quelconque des revendications 1 à 2, dans lequel une largeur de la structure conductrice (50) est comprise dans une plage allant de 0,6 mm à 1,5 mm, et une hauteur de la structure conductrice (50) est comprise dans une plage allant de 0,6 mm à 1,7 mm.

13. Dispositif électronique (200), dans lequel le dispositif électronique (200) comprend un boîtier (210) et l'assemblage de carte de circuit imprimé (100) selon l'une quelconque des revendications 1 à 12, et l'assemblage de carte de circuit imprimé (100) est logé dans le boîtier (210).
